# EUROPEAN PATENT APPLICATION

(11) **EP 4 782 857 A2**
(43) Date of publication of application: **29.07.2026**
(21) Application number: 26184356.9
(22) Date of filing: 19.05.2022
(51) Int. Cl.: G01R 31/396

(54) **METHOD OF GROUND FAULT TEST ON AGGREGATED BATTERY FOR ELECTRIC WORK VEHICLE AND APPARATUS**

(30) Priority: 25.06.2021 GB 202109194
(62) Divisional of application: 22729390.9
(71) Applicant: Caterpillar Inc., Peoria, IL 61629-9510 (US)
(72) Inventor: BUSBY, Robert David, Peoria, 61629-9510 (US)
(74) Representative: Boult Wade Tennant LLP

(57) **Abstract**

A method of performing a ground fault test on an aggregated battery for an electric work vehicle. The aggregated battery is not connected to the electric work vehicle, and includes a plurality of battery packs. A plurality of contactors are configured to facilitate connection to a circuit and disconnection from the circuit of each of the plurality of battery packs. A ground fault detection tool is connected to the circuit and to a battery management system service tool. If the isolation monitor detects existence of a ground fault, the plurality of contactors are opened. Closure of the plurality of contactors is sequenced to include each of the plurality of battery packs in the circuit with the isolation monitor in turn. The isolation monitor is used to determine whether the battery pack that is included in the circuit comprises a faulty battery pack. The faulty battery pack is disconnected.

## Description

### Field Of the Disclosure

The disclosure relates to the field of ground fault detection in electric work vehicles.

### Background

Electric work vehicles rely on rechargeable batteries, which may be susceptible to deterioration over time and may develop ground faults. For example, a cable rubbing against a casing may cause insulation to wear over time resulting in a conducting line coming into contact with the casing. Such a ground fault may be detected by using an isolation monitor to measure resistances.

An electric work vehicle may comprise an aggregated battery comprising a plurality of battery packs. A ground fault may affect only one of the battery packs.

It is known to install an isolation monitor at machine level to detect whether a ground fault exists. Although a ground fault may be detected in relation to the aggregated battery it may be helpful to be able to identify which of the individual battery packs has the ground fault so that the individual battery pack in question may be replaced. Typically, identification of which battery pack has a ground fault is achieved by installing individual isolation monitors in each battery pack, in addition to the machine level isolation monitor, which can be expensive and inefficient. If more than one of those isolation monitors are online at once then interference occurs, so they are conventionally taken offline until a fault is detected at machine level and then turned on one by one in sequence until the fault is isolated. In practice, a ground fault may trigger an alarm or notification at machine level, for example at key on, after which a user will need to sweep through the isolation monitors one by one in order to detect which of the battery packs has the fault. The battery pack with the fault may then be taken offline or replaced.

This ground fault detection may not be carried out during charging of the battery, or on a loose battery. It would be beneficial if ground fault detection could be carried out as part of a service or on a loose battery.

US 2015/219706 A1 describes an isolation test system for a vehicle that includes a communication interface, a current sensor, a plurality of impedances and a controller. The controller is programmed to electrically connect a selected one of the impedances between a traction battery of the vehicle and a low voltage subsystem of the vehicle. The connection creates a leakage path between the traction battery and the subsystem. The controller is further programmed to output a diagnostic status based on a current associated with the leakage path and a signal received via a communication interface indicative of an isolation fault between the battery and subsystem.

WO 2020/104508 A1 describes a battery system for a vehicle comprising a first electric conductor, a second electric conductor and a plurality of battery units individually arranged in-between the first electric conductor and the second electric conductor to form a plurality of individual electrical circuits for transferring electrical energy, wherein the battery system further comprises a group of controllable electromechanical contactors individually arranged between the plurality of battery units and the first electric conductor, respectively, each one of the controllable electromechanical contactors being operable to control a corresponding electrical connection between a corresponding battery unit and the first electric conductor.

DE 10 2011 011799 A1 a method for switching energy storage cells of energy storage device. The method involves checking an operating mode of energy storage cells and/or energy storage strands of an energy storage device. Only a part of the energy storage strands comprising an incorrect energy storage strand or an incorrect energy storage strand which comprises the energy storage cell having the incorrect operating mode is switched off by a contactor, if the operating mode of the energy storage cell or the respective energy storage strand is detected as incorrect.

### Summary Of the Disclosure

Against this background there is provided a method of performing a ground fault test on an aggregated battery for an electric work vehicle according to claim 1.The aggregated battery is not connected to the electric work vehicle. The aggregated battery comprises a plurality of battery packs and a plurality of contactors configured to facilitate connection to a circuit and disconnection from the circuit of each of the plurality of battery packs. The method comprises connecting a ground fault detection tool to the circuit. The method further comprises connecting the ground fault detection tool to a battery management system service tool. In an event that the isolation monitor detects existence of a ground fault, the method further comprises performing the following steps in order. Step (a) of opening the plurality of contactors. Step (b) of sequencing closure of the plurality of contactors to include each of the plurality of battery packs in the circuit with the isolation monitor in turn, and using the isolation monitor to determine whether the battery pack that is included in the circuit with the isolation monitor comprises a faulty battery pack, wherein the faulty battery pack comprises a ground fault. Step (c) of disconnecting the faulty battery pack or battery packs.

There is also provided a ground fault test apparatus for an aggregated battery for an electric work vehicle according to claim 9. The aggregated battery is not connected to the electric work vehicle. The aggregated battery comprises a plurality of battery packs and a plurality of contactors configured to facilitate connection to a circuit and disconnection from the circuit of each of the plurality of battery packs. The ground fault test apparatus comprises an isolation monitor that is configured to be connected to the aggregated battery and to a battery management system service tool for the electric work vehicle. In an event that the isolation monitor detects existence of a ground fault, the ground fault test apparatus and the battery management system service tool are configured to perform the following steps in order. At step (a), open the plurality of contactors. At step (b), sequence closure of the plurality of contactors to include each of the plurality of battery packs in the circuit with the isolation monitor in turn, and use the isolation monitor to determine whether the battery pack that is included in the circuit with the isolation monitor comprises a faulty battery pack, wherein the faulty battery pack comprises a ground fault. At step (c), disconnect the faulty battery pack or battery packs

In this way, the location of a ground fault among a plurality of battery packs may be determined by a single isolation monitor, and the faulty battery pack may be disconnected until it is possible to replace or repair it.

Aspects of the disclosure are provided by the following numbered clauses:
Clause 1: A method of performing a ground fault test on an aggregated battery for an electric work vehicle, wherein the aggregated battery is not connected to the electric work vehicle and wherein the aggregated battery comprises a plurality of battery packs and a plurality of contactors configured to facilitate connection to a circuit and disconnection from the circuit of each of the plurality of battery packs, the method comprising:
   connecting a ground fault detection tool to the circuit;
   connecting the ground fault detection tool to a battery management system service tool; and in an event that the isolation monitor detects existence of a ground fault, performing the following steps in order:
      (a) opening the plurality of contactors;
      (b) sequencing closure of the plurality of contactors to include each of the plurality of battery packs in the circuit with the isolation monitor in turn, and using the isolation monitor to determine whether the battery pack that is included in the circuit with the isolation monitor comprises a faulty battery pack, wherein the faulty battery pack comprises a ground fault; and
      (c) disconnecting the faulty battery pack or battery packs.
Clause 2: The method of clause 1 further comprising a step of notifying a user of the existence of the ground fault.
Clause 3: The method of any preceding clause further comprising a step of notifying the user of which of the plurality of battery packs is the faulty battery pack.
Clause 4: The method of any preceding clause wherein the plurality of battery packs are connected in parallel.
Clause 5: The method of clause 4 wherein the plurality of contactors are to a negative side of the circuit.
Clause 6: The method of any preceding clause wherein the battery management system service tool communicates with the isolation monitor and the battery over a controller area network.
Clause 7: The method of any preceding clause wherein sequencing closure of the plurality of contactors to include each of the plurality of battery packs in the circuit with the isolation monitor in turn comprises including only one of the plurality of battery packs in the circuit with the isolation monitor at a given time.
Clause 8: The method of any preceding clause wherein prior to the step of sequencing closure of the plurality of contactors to include each of the plurality of battery packs in the circuit with the isolation monitor in turn, the method further comprises a step of sequencing closure of the plurality of contactors to include more than one of the plurality of battery packs in the circuit with the isolation monitor at a given time, and using the isolation monitor to determine whether the battery packs that are included in the circuit with the isolation monitor comprise a faulty battery pack.
Clause 9: The method of any preceding clause wherein after the faulty battery pack is disconnected the isolation monitor is used to determine whether an additional ground fault exists in the aggregated battery and wherein:
   in the event that the additional ground fault exists the additional ground fault is located; and
   in the event that the additional ground fault does not exist the method terminates.
Clause 10: A ground fault test apparatus for an aggregated battery for an electric work vehicle, wherein the aggregated battery is not connected to the electric work vehicle and wherein the aggregated battery comprises a plurality of battery packs and a plurality of contactors configured to facilitate connection to a circuit and disconnection from the circuit of each of the plurality of battery packs, wherein the ground fault test apparatus comprises an isolation monitor that is configured to be connected to:
   the aggregated battery; and
   a battery management system service tool for the electric work vehicle;
   wherein in an event that the isolation monitor detects existence of a ground fault, the ground fault test apparatus and the battery management system service tool are configured to perform the following steps in order:
      (a) open the plurality of contactors;
      (b) sequence closure of the plurality of contactors to include each of the plurality of battery packs in the circuit with the isolation monitor in turn, and use the isolation monitor to determine whether the battery pack that is included in the circuit with the isolation monitor comprises a faulty battery pack, wherein the faulty battery pack comprises a ground fault; and
      (c) disconnect the faulty battery pack or battery packs.
Clause 11: A ground fault test apparatus for an aggregated battery for an electric work vehicle, wherein the aggregated battery is not connected to the electric work vehicle and wherein the aggregated battery comprises a plurality of battery packs and a plurality of contactors configured to facilitate connection to a circuit and disconnection from the circuit of each of the plurality of battery packs, wherein the ground fault test apparatus comprises an isolation monitor that is configured to be connected to:
   the aggregated battery; and
   a battery management system service tool for the electric work vehicle;
   wherein in an event that the isolation monitor detects existence of a ground fault, the ground fault test apparatus and the battery management system service tool are configured to perform the method of any of clauses 1 to 9.
Clause 12: The ground fault test apparatus of clauses 10 or 11 wherein the battery management system service tool communicates with the isolation monitor and the battery over a controller area network.
Clause 13: The ground fault test apparatus of any of clauses 10 to 12 wherein the ground fault test apparatus is further configured to notify a user of the existence of the ground fault.
Clause 14: The ground fault test apparatus of any of clauses 10 to 13 wherein the ground fault test apparatus is further configured to notify the user of which of the plurality of battery packs is the faulty battery pack.
Clause 15: The ground fault test apparatus of any of clauses 10 to 14 wherein sequencing closure of the plurality of contactors to include each of the plurality of battery packs in the circuit with the isolation monitor in turn comprises including only one of the plurality of battery packs in the circuit with the isolation monitor at a given time.

### Brief Description of The Drawings

A specific embodiment of the disclosure will now be described, by way of example only, with reference to the accompanying drawings in which:
Figure 1 shows a schematic diagram of a plurality of battery packs connected to an isolation monitor in accordance with an embodiment of the present disclosure.
Figure 2 shows a flowchart illustrating a method of ground fault location in accordance with an embodiment of the present disclosure.
Figure 3 shows a flowchart illustrating a method of ground fault location in accordance with an embodiment of the present disclosure.
Figure 4 shows a schematic diagram of ground fault location in batches of battery packs in accordance with an embodiment of the present disclosure.
Figure 5 shows a schematic diagram of an aggregated battery connected to an isolation monitor and a battery management system service tool in accordance with an embodiment of the present disclosure.

### Detailed Description

According to an embodiment of this disclosure, there is provided a method of ground fault location for an aggregated battery for an electric work vehicle, the aggregated battery comprising a plurality of battery packs. A circuit is configured to connect the plurality of battery packs to each other, to a ground fault detection tool and to a battery management system (BMS) service tool. The ground fault detection tool comprises an isolation monitor. The ground fault detection tool shall be referred to as an isolation monitor throughout the specification, but is not limited to comprising an isolation monitor. The circuit comprises a plurality of contactors configured to disconnect each of the plurality of battery packs from the circuit. The plurality of contactors may comprise one or more contactors for each of the plurality of battery packs. The plurality of battery packs may comprise the plurality of contactors, or the plurality of contactors may be part of the circuit external to the plurality of battery packs. The method comprises using the isolation monitor to detect whether a ground fault exists. The plurality of connectors are opened to disconnect all battery packs from the circuit. It is determined which of the battery packs is faulty by sequencing closure of the plurality of contactors to include each of the plurality of battery packs in the circuit with the isolation monitor. The faulty battery pack is disconnected.

There is also provided a ground fault location apparatus for an aggregated battery for an electric work vehicle, configured to locate a ground fault. The aggregated battery comprises a plurality of battery packs. The ground fault location apparatus comprises a battery management system (BMS) service tool and an isolation monitor. A circuit is configured to connect the plurality of battery packs to the isolation monitor and to the BMS service tool, wherein the circuit comprises a plurality of contactors configured to disconnect each of the plurality of battery packs from the circuit. The ground fault location apparatus is configured to locate a ground fault by using the isolation monitor to detect existence of a ground fault. In the event that a ground fault is detected, the apparatus uses the battery management system to open the plurality of contactors and to locate the ground fault in a faulty battery pack by sequencing closure of the plurality of contactors to include each of the plurality of battery packs in a circuit with the isolation monitor. The apparatus disconnects the faulty battery pack.

In this way, the location of a ground fault among a plurality of battery packs may be determined by an isolation monitor and service tool, and the faulty battery pack may be disconnected until it is possible to replace it.

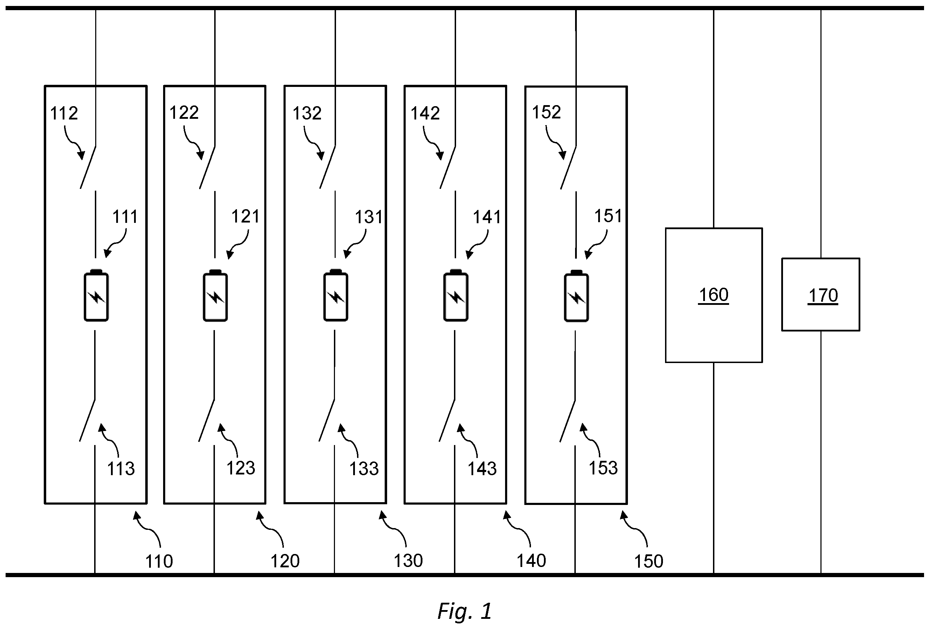

With reference to Figure 1, a schematic diagram of the circuit connecting the plurality of battery packs to the isolation monitor is shown according to an embodiment of the disclosure. The aggregated battery comprises at least one battery pack. In the exemplary embodiment illustrated in Figure 1, five (5) battery packs 110, 120, 130, 140 and 150 are shown. It will be understood that the aggregated battery may comprise fewer or more battery packs than are illustrated in Figure 1. Each battery pack 110, 120, 130, 140 and 150 comprises a power storage module 111, 121, 131, 141 and 151, a first contactor 112, 122, 132, 142 and 152, and a second contactor 113, 123, 133, 143 and 153. Figure 1 shows the first contactors 112, 122, 132, 142 and 152, and the second contactors 113, 123, 133, 143 and 153 in the open position such that the battery packs 110, 120, 130, 140 and 150 are disconnected from the circuit. It will be understood that each of the contactors may be open or closed. In normal use when the aggregated battery is on an electric work vehicle, all contactors would be expected to be closed such that all the battery packs are included in the circuit. In a method according to an embodiment of the disclosure (described later), at a given time the contactors may be all closed, all open, or a mixture of open and closed. In other embodiments, each battery pack may comprise one or more contactors. In other embodiments, each battery pack may comprise no contactors and each battery pack may be connected to a part of the circuit comprising one or more contactors such that each battery pack may be individually connected to and disconnected from the circuit.

The power storage modules 111, 121, 131, 141 and 151 may comprise rechargeable power storage modules. The plurality of battery packs 110, 120, 130, 140 and 150 may be connected in parallel to each other. The isolation monitor 160 is configured to be connected in a circuit with the plurality of battery packs 110, 120, 130, 140 and 150. The BMS service tool 170 may be connected to the plurality of battery packs 110, 120, 130, 140 and 150 and to the isolation monitor 160. The BMS service tool 170 may be connected to the plurality of battery packs 110, 120, 130, 140 and 150 and to the isolation monitor 160 via a controller area network. The isolation monitor may communicate with the BMS service tool over the controller area network (CAN).

In an embodiment, the plurality of contactors may comprise relay switches. In another embodiment, the plurality of contactors may be on a negative side of the circuit.

A battery pack may comprise a single power storage module, or a plurality of power storage modules. A battery pack may be referred to elsewhere as a battery or a battery module.

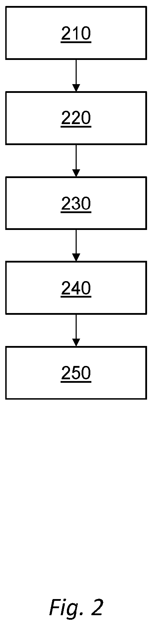

A method of ground fault location according to an embodiment of the present disclosure is illustrated by the flow diagram of Figure 2. The method may be for an aggregated battery comprising a plurality of battery packs (110, 120, 130, 140 and 150 as illustrated in Figure 1, although it will be understood that there may be fewer or more battery packs), an isolation monitor 160 and a circuit configured to connect the plurality of battery packs 110, 120, 130, 140 and 150 to the isolation monitor 160, wherein the circuit comprises a plurality of contactors (112, 122, 132, 142,152, 113, 123, 133, 143 and 153 in Figure 1) configured to disconnect each of the plurality of battery packs 110, 120, 130, 140 and 150 from the circuit. The method may comprise a step 210 of using the isolation monitor 160 to detect whether a ground fault exists. In the event that a ground fault exists, at step 220 a user may be notified that a ground fault exists. At least one contactor per battery pack may be opened at step 230 to disconnect the plurality of battery packs from the circuit. For example, with reference to Figure 1, contactors 113, 123, 133, 143 and 153 may be opened. At step 240, a faulty battery pack that comprises the ground fault is located among the plurality of battery packs by testing each battery pack in turn using the isolation monitor 160. Step 240 may comprise sequencing closure of the plurality of contactors (for example 113, 123, 133, 143 and 153) to include each of the plurality of battery packs (for example 110, 120, 130, 140 and 150) in the circuit with the isolation monitor 160 in turn. The sequencing may involve closure of one of the plurality of contactors (for example 113, 123, 133, 143 and 153) at any one time. The faulty battery pack is disconnected at step 250. The faulty battery pack may remain disconnected until it is repaired or replaced.

In an embodiment, the method may further comprise a step of notifying the user which battery pack is faulty and/or that the faulty battery pack requires repairing or replacing

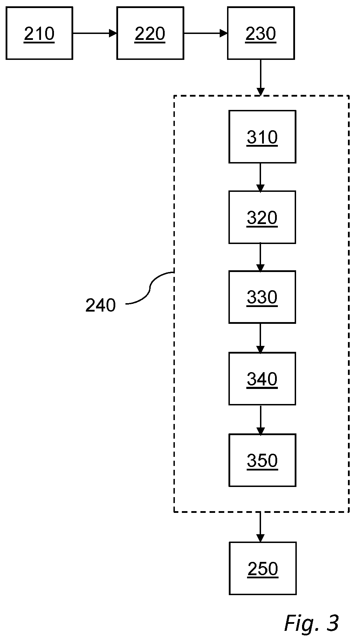

Step 240 of locating the faulty battery pack may comprise closing a contactor in each of the plurality of battery packs in turn. When an individual battery pack is included in the circuit with the isolation monitor 160, the isolation monitor will determine whether there is a ground fault in that battery pack. With reference to Figure 3, a method according to an embodiment of the disclosure is illustrated for the apparatus illustrated in Figure 1 comprising 5 battery packs 110, 120, 130, 140 and 150. Where steps are the same as those in Figure 2, they share reference numerals. At step 230 the contactors 113, 123, 133, 143 and 153 may be opened. Contactors 112, 122, 132, 142 and 152 may remain closed. Step 240 may then comprise closing each of the open contactors 113, 123, 133, 143 and 153 one by one, so that the plurality of battery packs 110, 120, 130, 140 and 150 are included in the circuit with the isolation monitor 160 one by one. Step 310 may comprise closing contactor 112, using the isolation monitor to detect whether there is a ground fault in battery pack 110, and then opening contactor 112. Step 320 may comprise closing contactor 122, using the isolation monitor to detect whether there is a ground fault in battery pack 120, and then opening contactor 122. Step 330 may comprise closing contactor 132, using the isolation monitor to detect whether there is a ground fault in battery pack 130, and then opening contactor 132. Step 340 may comprise closing contactor 142, using the isolation monitor to detect whether there is a ground fault in battery pack 140, and then opening contactor 142. Step 350 may comprise closing contactor 152, using the isolation monitor to detect whether there is a ground fault in battery pack 150, and then opening contactor 152.

In the event that a fault is found in a given battery pack, the method may continue to check the remaining battery packs. In another embodiment, the method may close all contactors to include all of the plurality of battery packs in the circuit with the isolation monitor 160 to check that there is no remaining ground fault. In the event that there is no remaining ground fault, the method ends. In the event that a ground fault remains, the method resumes sequencing the remaining battery packs.

In another embodiment, step 240 may comprises including batches of the plurality of battery packs in a circuit with the isolation monitor 160, in order to narrow down the location of the ground fault. For example, in the event that the aggregated battery comprises *x* battery packs, step 240 may comprise including a first batch of *x*/*2* battery packs in the circuit with the isolation monitor 160 and then including the second batch of *x*/*2* battery packs in the circuit with the isolation monitor 160. It may then be determined which batch of *x*/*2* battery packs comprises the faulty battery pack. The batch of *x*/*2* battery packs that comprises the faulty battery pack may be included one by one in the circuit with the isolation monitor 160 or split into further batches of *x*/*4* battery packs. In this way, the isolation monitor 160 may need to make fewer tests than when including each battery pack in the circuit with the isolation monitor 160 one by one. It will be understood that this method may be carried out with different numbers of batches of battery packs containing different proportions of the total number of battery packs. There may be fewer or more iterations of splitting into batches. The smallest batch size may be larger than one. There may be overlap between batches, such that a particular battery pack is included in more than one batch in a given iteration.

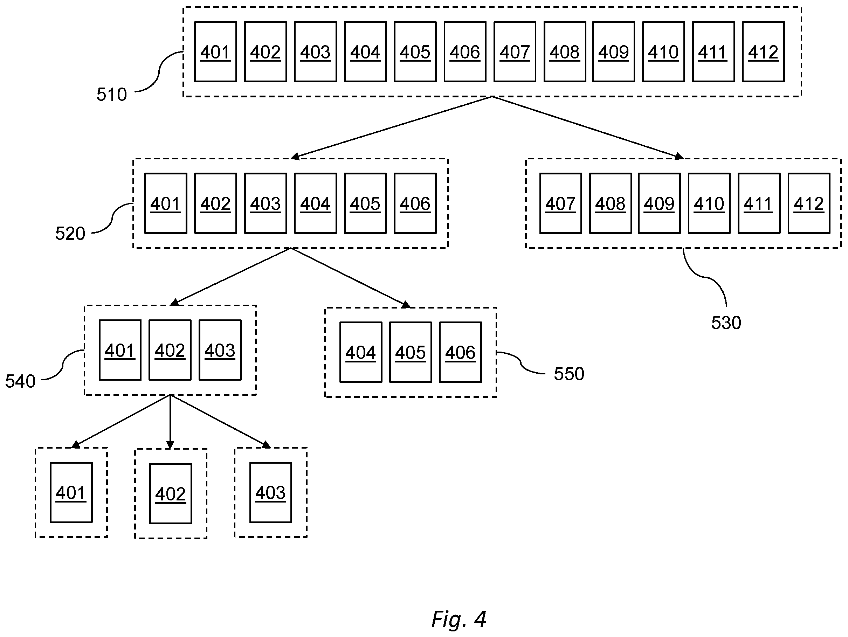

An example of testing of battery packs in batches is illustrated in Figure 4. The aggregated battery 510 comprises twelve battery packs 401 to 412. The aggregated battery 510 may be split into a first batch 520 comprising six battery packs 401 to 406, and a second batch 530 comprising six battery packs 407 to 412. To test the first batch 520, the first batch 520 may be included in the circuit with the isolation monitor 160 by closing all contactors of the first batch 520 and opening a contactor in each battery pack of the second batch 530. To test the second batch 530, the second batch 530 may be included in the circuit with the isolation monitor 160 by closing all contactors of the second batch 530 and opening a contactor in each battery pack of the first batch 520. Once it has been determined which batch contains the faulty battery pack, that batch may be split into two sub-batches each containing 3 battery packs. In the exemplary scenario illustrated in Figure 4, the first batch 520 is found to be faulty and is split into a first sub-batch 540 comprising battery packs 401 to 403 and a second sub-batch 550 comprising battery packs 404 to 406. To test the first sub-batch 540, the first sub-batch 540 may be included in the circuit with the isolation monitor 160 by closing all contactors of the first sub-batch 540 and opening a contactor in each battery pack of the second sub-batch 550. To test the second sub-batch 550, the second sub-batch 550 may be included in the circuit with the isolation monitor 160 by closing all contactors of the second sub-batch 550 and opening a contactor in each battery pack of the first sub-batch 540. Once it has been determined which sub-batch contains the faulty battery pack, each battery pack within the sub-batch may be tested one by one by including it in the circuit with isolation monitor 160. In the exemplary scenario illustrated in Figure 4 the faulty battery pack is found to be in the first sub-batch 540, and battery packs 401, 402 and 403 are included one by one in the circuit with the isolation monitor. In this way, the isolation monitor makes seven tests (rather than the twelve tests required if each of the twelve battery packs is tested in turn). The aggregated battery 510 may alternatively be split into three batches each containing four battery packs. Each batch of four battery packs may be split into two sub-batches of two battery packs.

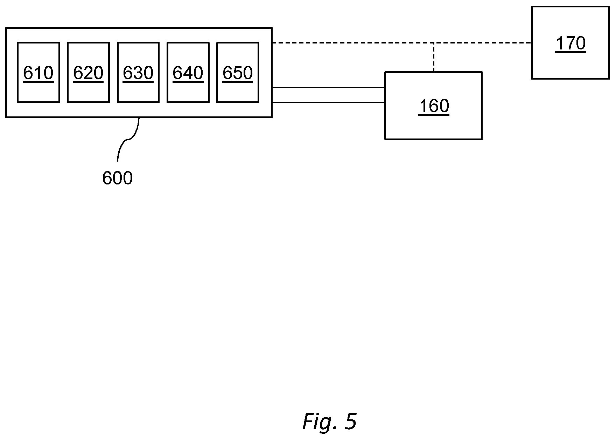

Figure 5 illustrates an exemplary arrangement in which the isolation monitor 160 is connected to the aggregated battery 600, wherein the aggregated battery 600 comprises a plurality of battery packs 610, 620, 630, 640 and 650. The BMS service tool 170 is connected to the aggregated battery 600 and to the isolation monitor 160 via a CANbus (indicated by the dashed line). In use, a user may fit the isolation monitor 160 (or ground fault detection tool) between the aggregated battery 600 and the BMS service tool 170.

## Claims

1. A method of performing a ground fault test on an aggregated battery for an electric work vehicle, wherein the aggregated battery is not connected to the electric work vehicle and wherein the aggregated battery comprises:
a plurality of battery packs (110, 120, 130, 140, 150) connected in parallel to each other; and
a plurality of contactors configured to facilitate connection to a circuit and disconnection from the circuit of each of the plurality of battery packs (110, 120, 130, 140, 150), wherein at least one contactor is in series with each battery pack;
the method comprising:
connecting a ground fault detection tool to the circuit in parallel with the plurality of battery packs, wherein the ground fault detection tool comprises an isolation monitor (160);
connecting the ground fault detection tool to a battery management system service tool (170); and
wherein in an event that the isolation monitor (160) detects existence of a ground fault, the method further comprises performing the following steps in order:
(a) opening the plurality of contactors;
(b) sequencing closure of the plurality of contactors to include a batch of more than one of the plurality of battery packs (110, 120, 130, 140, 150) in the circuit with the isolation monitor at a given time (160), and using the isolation monitor (160) to determine whether the battery packs that are included in the circuit with the isolation monitor (160) comprise a faulty battery pack;
(c) in an event that the batch of battery packs comprises a faulty battery pack, sequencing closure of the plurality of contactors to include each of the batch of battery packs in the circuit with the isolation monitor (160) in turn, and using the isolation monitor (160) to determine whether the battery pack that is included in the circuit with the isolation monitor (160) comprises a faulty battery pack, wherein the faulty battery pack comprises a ground fault; and
(d) disconnecting the faulty battery pack or battery packs.

2. The method of claim 1 further comprising a step of notifying a user of the existence of the ground fault.

3. The method of any preceding claim further comprising a step of notifying the user of which of the plurality of battery packs (110, 120, 130, 140, 150) is the faulty battery pack.

4. The method of claim 1 wherein the plurality of contactors are to a negative side of the circuit.

5. The method of any preceding claim wherein step (c) of sequencing closure of the plurality of contactors to include each of the batch of battery packs in the circuit with the isolation monitor in turn comprises including only one of the plurality of battery packs in the circuit with the isolation monitor at a given time.

6. The method of any preceding claim wherein after the faulty battery pack is disconnected the isolation monitor (160) is used to determine whether an additional ground fault exists in the aggregated battery and wherein:
in the event that the additional ground fault exists the additional ground fault is located; and
in the event that the additional ground fault does not exist the method terminates.

7. A ground fault test apparatus for an aggregated battery for an electric work vehicle, wherein the aggregated battery is not connected to the electric work vehicle and wherein the aggregated battery comprises:
a plurality of battery packs (110, 120, 130, 140, 150) connected in parallel to each other; and
a plurality of contactors configured to facilitate connection to a circuit and disconnection from the circuit of each of the plurality of battery packs (110, 120, 130, 140, 150), wherein at least one contactor is in series with each battery pack;
wherein the ground fault test apparatus comprises an isolation monitor that is configured to be connected to:
the aggregated battery in parallel with the plurality of battery packs; and
a battery management system service tool (170) for the electric work vehicle;
wherein in an event that the isolation monitor (160) detects existence of a ground fault, the ground fault test apparatus and the battery management system service tool (170) are configured to perform the following steps in order:
(a) open the plurality of contactors;
(b) sequence closure of the plurality of contactors to include a batch of more than one of the plurality of battery packs (110, 120, 130, 140, 150) in the circuit with the isolation monitor at a given time (160), and use the isolation monitor (160) to determine whether the battery packs that are included in the circuit with the isolation monitor (160) comprise a faulty battery pack;
(c) in an event that the batch of battery packs comprises a faulty battery pack, sequence closure of the plurality of contactors to include each of the batch of battery packs in the circuit with the isolation monitor (160) in turn, and use the isolation monitor (160) to determine whether the battery pack that is included in the circuit with the isolation monitor (160) comprises a faulty battery pack, wherein the faulty battery pack comprises a ground fault; and
(d) disconnect the faulty battery pack or battery packs.

8. The ground fault test apparatus of claim 7wherein the battery management system service tool (170) is configured to communicate with the isolation monitor (160) and the battery over a controller area network.

9. The ground fault test apparatus of claim 7 or 8 wherein the ground fault test apparatus is further configured to notify a user of the existence of the ground fault.

10. The ground fault test apparatus of any of claims 7 to 9 wherein the ground fault test apparatus is further configured to notify the user of which of the plurality of battery packs is the faulty battery pack.

11. The ground fault test apparatus of any of claims 7 to 10 wherein sequencing closure of the plurality of contactors to include each of the batch of battery packs in the circuit with the isolation monitor in turn comprises including only one of the plurality of battery packs in the circuit with the isolation monitor at a given time.

12. The ground fault test apparatus of claim 7 wherein the plurality of contactors are to a negative side of the circuit.

13. The ground fault test apparatus of any of claims 7 to 12 wherein after the faulty battery pack is disconnected the isolation monitor (160) is used to determine whether an additional ground fault exists in the aggregated battery and wherein:
in the event that the additional ground fault exists the additional ground fault is located; and
in the event that the additional ground fault does not exist the method terminates.
